# EUROPEAN PATENT SPECIFICATION

(11) **EP 1 351 316 B1**
(45) Date of publication and mention of the grant of the patent: **18.01.2012**
(21) Application number: 03006168.3
(22) Date of filing: 19.03.2003
(51) Int. Cl.: H01L 31/0203, H01L 31/0232, H01L 27/146

(54) **Image pickup device and producing method thereof**
Bildaufnahmevorrichtung und Herstellungsverfahren
Dispositif de prise d'images et méthode de fabrication

(30) Priority: 22.03.2002 JP 2002081871
(43) Date of publication of application: 08.10.2003
(73) Proprietor: KONICA CORPORATION, Tokyo (JP)
(72) Inventor: Tansho, Kazuo, Hachioji-shi, Tokyo 192-8505 (JP); Saruya, Nobuhiro, Hachioji-shi, Tokyo 192-8505 (JP); Atarashi, Yuichi, Hachioji-shi, Tokyo 192-8505 (JP); Mizukami, Masafumi, Hachioji-shi, Tokyo 192-8505 (JP)
(74) Representative: Gille Hrabal Struck Neidlein Prop Roos

(56) References cited:
- EP-A2- 0 864 902
- WO-A-01/43202
- JP-A- 11 121 653
- JP-A- 11 220 115
- JP-A- 2001 245 186
- US-A- 5 682 218
- US-A1- 2002 003 705
- US-A1- 2002 154 239
- PATENT ABSTRACTS OF JAPAN vol. 2000, no. 07, 29 September 2000 (2000-09-29) -& JP 2000 125212 A (OLYMPUS OPTICAL CO LTD), 28 April 2000 (2000-04-28) -& US 6 762 796 B1 (NAKAJOH YASUO ET AL) 13 July 2004 (2004-07-13)
- PATENT ABSTRACTS OF JAPAN vol. 1998, no. 04, 31 March 1998 (1998-03-31) -& JP 09 312809 A (SONY CORP), 2 December 1997 (1997-12-02)
- PATENT ABSTRACTS OF JAPAN vol. 2003, no. 02, 5 February 2003 (2003-02-05) -& JP 2002 320122 A (KONICA CORP), 31 October 2002 (2002-10-31)

## Description

The present invention relates to an image pickup device and a producing method for the same.

In recent years, there have been developed small-sized and highly efficient image pickup devices which can be housed in a cellphone and a personal computer.

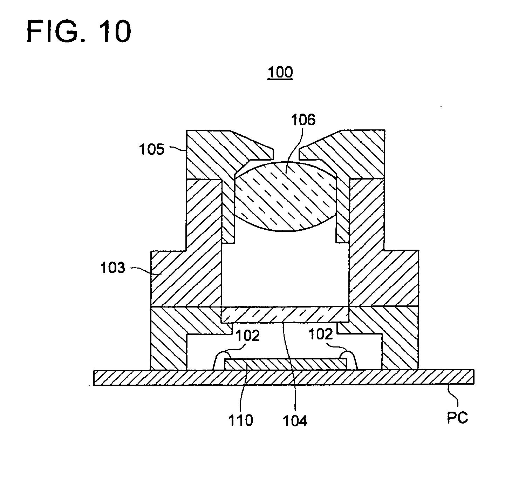

Fig. 10 is a sectional view showing an example of image pickup device 100 of this kind. As shown in Fig. 10, in image pickup device 100, image sensor 110 is arranged on base board PC which is of glass epoxy, and is connected to image processing IC circuit provided on the base board PC through a number of wires 102 coming from a terminal (not shown) on the top.

There is further arranged lens frame 103 representing an outer frame member in a way to cover the image sensor 110, and the lens frame 103 is glued on the base board PC with adhesive B. Lens 106 is provided on the upper portion of the lens frame 103, and infrared blocking filter 104 is arranged between the lens 106 and the image sensor 110.

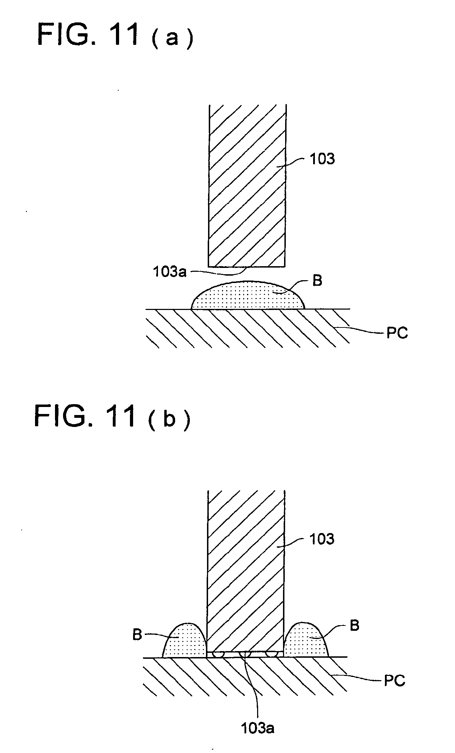

In image pickup device 100, however, if the adhesive B is applied first on the base board PC as shown in Fig. 11(a), and then, is pressed by bottom surface portion 103a of the lens frame 103 from the upper portion for gluing in the gluing process between the base board PC and the lens frame 103, the adhesive B is pressed by the base board PC and by the lens frame 103 to move out of the lens frame 103. Further, in the case of gluing, bubbles are sometimes formed between the base board PC and the bottom surface portion 103a. As a result, the area for the adhesive B to be in contact with both the lens frame 103 and the base board PC becomes small, resulting in weak adhesion force between the lens frame 103 and the base board PC, which is a problem.

When adhesion force between the base board PC and the lens frame 103 is weak, there is a fear that the lens frame 103 comes off when the image pickup device 100 is used. Further, if adhesion strength is weak after the lens frame 103 has been glued, the lens frame 103 is sometimes shifted or it comes off, and the lens frame 103 needs to be glued again, which is inconvenient.

If the amount of adhesive B is increased to apply it on the side of the lens frame 103 and on the surface of the base board PC, to make adhesion between the base board PC and the lens frame 103 to be stronger, an increase in manufacturing cost is unavoidable. In addition, the thickness of adhesive B existing between the base board PC and the bottom surface portion 103a of the lens frame 103 is varied to cause uneven height of the lens frame 103, which makes adjustment in assembling to be difficult.

On the other hand, in the assembly process for image pickup device 100 after adhesion of the lens frame 103, it is necessary to advance to the next process after the adhesive B is hardened thoroughly, for preventing that the lens frame 103 is shifted from or comes off the base board PC. However, this lengthens the cycle time required for production of image pickup devices 100, which is inconvenient from the viewpoint of productivity. In addition, if the adhesive B is hardened thoroughly, fine adjustment in assembling process after adhesion of the lens frame 103 is difficult, which causes a problem that the degree of freedom in assembling is lost and assembly work is difficult.

An example of an image pickup device having a frame for covering a semiconductor chip is disclosed by JP-A-2000-125 212.

With exception of its four corners the frame has a flat bottom. At each of the corners a tapering projection is provided with which the frame rests on the surface of the base board.

The document JP-A-09 312 809 discloses an image pickup device in which the leg part of a lens structure is fixed to a substrate which is provided with an image sensor A chamfer is formed at a prescribed angle from a side surface toward the bottom surface of the leg part and an adhesive is coated on a slope of the chamfer and on the bottom surface which is left after chamfering, so that the leg part is glued on the substrate.

The object of the invention is to provide an image pickup device and a producing method thereof wherein an outer frame member and a base board can be glued together more firmly and assembling these parts can be conducted properly.

This object is attained by a pickup device having the features of claim 1. Improvements of this device and further features thereof are subject matter of the claims dependent to claim 1.

Furthermore, this object is attained by a producing method having the features of claim 6. An improvement of this method is subject matter of claim 7.

According to the present invention in an image pickup device comprising an image sensor and an outer frame member glued to a base to cover the image sensor, the area of adhesion between the outer frame member and the adhesive is enlarged so that the adhesive touches the frame member not only on the bottom surface of the outer frame member but also on a chamfer of the outer frame member. Due to the provision of the serrated portion formed in the slope of the chamfer the area of adhesion is further enlarged so that adhesion between the outer frame member and the base board is more firm.

In the image pickup device according to the present invention the position of the optical member is regulated by the outer frame member and by either one of the base board and the image sensor.

Since the chamfer is formed on the adhesion part, when the outer frame member is pressed down to be glued after the adhesive is coated on the base board, the adhesive is not pushed out, and the chamfer can enter the adhesive, thus, it is possible to make the area of adhesion to be large. Further, since the chamfer can make the outer frame member to be fixed firmly enough on the base board, it is possible to prevent that the height of the outer frame member on the base board becomes uneven, by assembling while keeping the bottom surface of the outer frame member to be in contact with the base board, resulting in easy assembly work.

If the chamfer is formed on each of the inner side and the outer side of the outer frame member, the area of adhesion between the adhesive and the outer frame member can be made larger, and adhesion between the outer frame member and the base board can be more firm.

If a concave portion and a convex portion of the serrated portion are formed to be in direction from the bottom surface of the outer frame member to the side surface thereof it is possible to prevent that bubbles are formed on the serrated portion when the outer frame member is glued on the base board, and thereby to fix the outer frame member and the base board together on a larger area of adhesion.

The adhesive which sticks the base board and the outer frame member together is according to the present invention a resin of a compound hardening type having both characteristics to be hardened by ultraviolet radiation and to be hardened by another hardening means.

It is possible to use a process for hardening the adhesive by dividing into two steps, depending on the characteristics of the adhesive to be hardened by ultraviolet radiation and on the characteristics to be hardened by another hardening means. Namely, after sticking the outer frame member on the base board with adhesive in the course of assembling the image pickup device, the adhesive is hardened to a certain extent by the hardening means by ultraviolet radiation or by another hardening means, then, assembling is resumed again, and the other hardening means is used to harden the resin thoroughly. Thereby, it is possible to assemble with a degree of freedom to a certain extent in the course of assembling, thus, it is possible to fix more firmly after termination of assembling. It is therefore possible to fix the outer frame member firmly, while securing a degree of freedom to a certain extent in the assembling process.

Accordingly, it is possible to advance to the following assembly process after temporal fixing by hardening the adhesive to a certain extent, without waiting until the adhesive is hardened thoroughly, in the case of mounting the outer frame member on the base board. Therefore, the cycle time for production can be shortened, and productivity can be improved.

By using the adhesive of a compound hardening type, it is easy to control timing for hardening the adhesive, by using plural hardening means properly.

Another hardening means is water. Namely, it is possible to use an adhesive of a compound hardening type having characteristics to be hardened by water and characteristics to be hardened by ultraviolet radiation. In this case, the adhesive is hardened by water, and therefore, the adhesive absorbs moisture in the image pickup device, and the inside of the image pickup device can be dried.

Another hardening means is heat. Namely, it is possible to use an adhesive of a compound hardening type having characteristics to be hardened by heat and characteristics to be hardened by ultraviolet radiation. In this case, the adhesive is hardened by heat, and therefore, the adhesive can be given heat to be hardened, and the inside of the image pickup device can be dried.

Another hardening means is a hardening agent and/or a hardening-promoter. Namely, it is possible to use an adhesive of a compound hardening type having characteristics to be hardened by hardening an agent and/or hardening-promoter and characteristics to be hardened by ultraviolet radiation.

For producing an image pickup device equipped with a base board provided with an image sensor, an outer frame member that is glued on the base board and covers at least the image sensor and an optical member for converging light on the image sensor, the adhesive sticking the base board and the outer frame member together is a resin of a compound hardening type having characteristics to be hardened by ultraviolet radiation and characteristics to be hardened by another hardening means. There is provided a process to make the base board and the outer frame member to touch each other after coating the adhesive on an adhesion part for the base board or the outer frame member, the first hardening process to harden the resin coated on the adhesion part by the ultraviolet radiation, and the second hardening process to harden the resin coated on the adhesion part by the other hardening means, and the first hardening process and the second hardening process are conducted separately.

In producing an image pickup device, there are provided a process to make the base board and the outer frame member to touch each other after coating the adhesive on an adhesion part for the base board or the outer frame member, the first hardening process to harden a resin coated on the adhesion part by ultraviolet radiation, and the second hardening process to harden the resin by other hardening means. It is possible to stick the outer frame member on the base board by dividing fixing into temporal fixing and regular fixing, by conducting the first hardening process and the second hardening process separately, such as conducting either one of them first and conducting the other later. Due to this, the degree of freedom in the producing process after fixing the outer frame member becomes high, and image pickup devices can be produced conveniently.

Further, when fixing the outer frame member on the base board, it is possible to fix temporarily by hardening an adhesive to a certain extent without waiting until the adhesive is hardened thoroughly, and to advance to the following assembly process. Therefore, the cycle for production can be shortened, and productivity can be improved.

Further, by using an adhesive of a compound hardening type, it is possible to use a plurality of hardening means properly, and thereby, timing for hardening the adhesive can be controlled easily, which is preferable.

In producing an image pickup device according to the present invention the first hardening by ultraviolet radiation is made to be a temporal fixing process, and the second hardening by the other hardening means is made to be a regular fixing process.

Namely, in irradiation of ultraviolet radiation, temporal fixing can be conducted properly, because the extent of hardening for an adhesive can be adjusted by changing intensity of ultraviolet radiation. Further, since ultraviolet radiation can harden an adhesive in a relatively short period of time, influence on the cycle time for assembling is small, which is preferable. In the regular fixing of the adhesive after the assembly process, a cooling time in the case of using a hardening means by heat is necessary, and a water absorbing time is necessary in the case of hardening by moisture, and further, a prescribed hardening time is required even when using a hardening agent and/or hardening promoter. However, all of them are needed after assembling, and therefore, influence on the cycle time for assembly is small, and it is possible to harden the adhesive gradually and surely after assembly, which is preferable.

The invention is hereinafter described by means of embodiments shown in the drawings, wherein.
Fig. 1 is a sectional view of an image pickup device in accordance with the invention,
Fig. 2 is a perspective view of the image pickup device of Fig. 1.
Fig. 3 is a perspective view of an optical member of the embodiment shown in Fig. 1 and 2,
Fig. 4 is a bottom face view of the optical member in Fig. 3,
Fig. 5 is a sectional view of a primary portion taken on line V - V in Fig. 1,
Fig. 6 is a top face view of an image sensor and a base board relating to the invention,

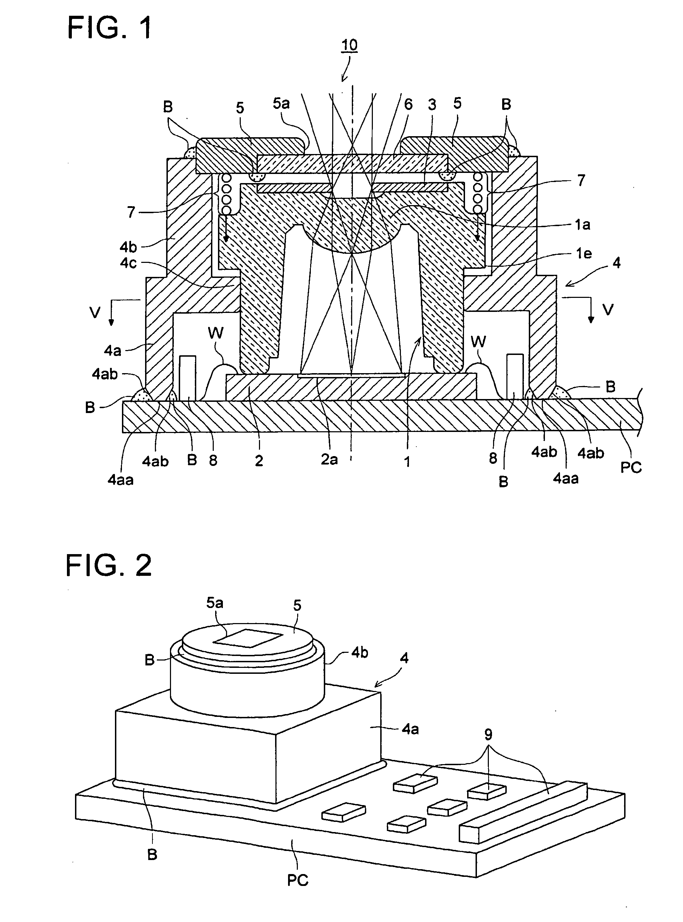

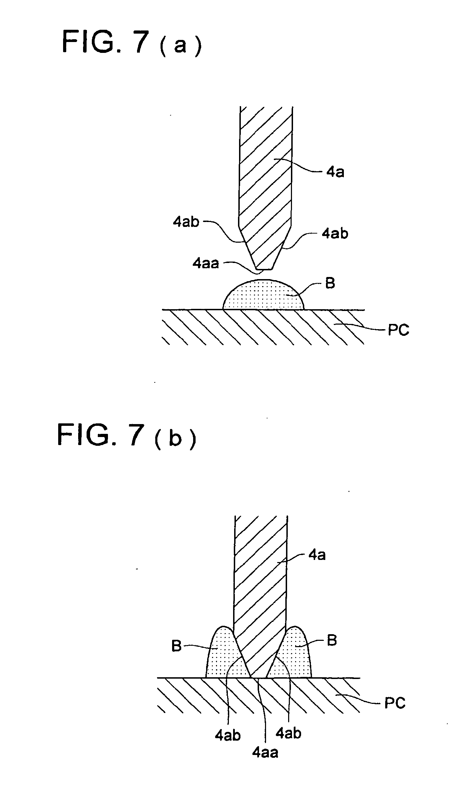

Each of Fig. 7(a) and Fig. 7(b) is a sectional view showing how an outer frame member glued on a base board in the image pickup device of Fig. 1,

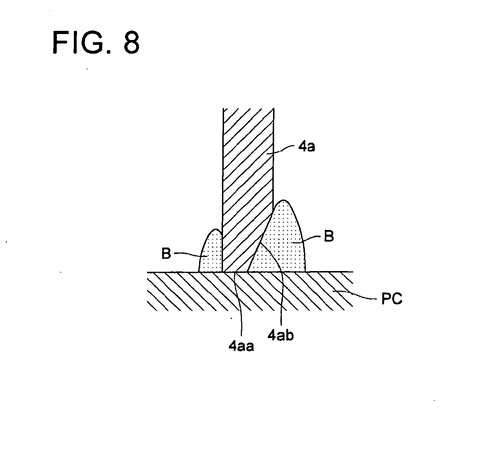

Fig. 8 is a sectional view showing how an outer frame member is glued on a base board as another example of the present invention,

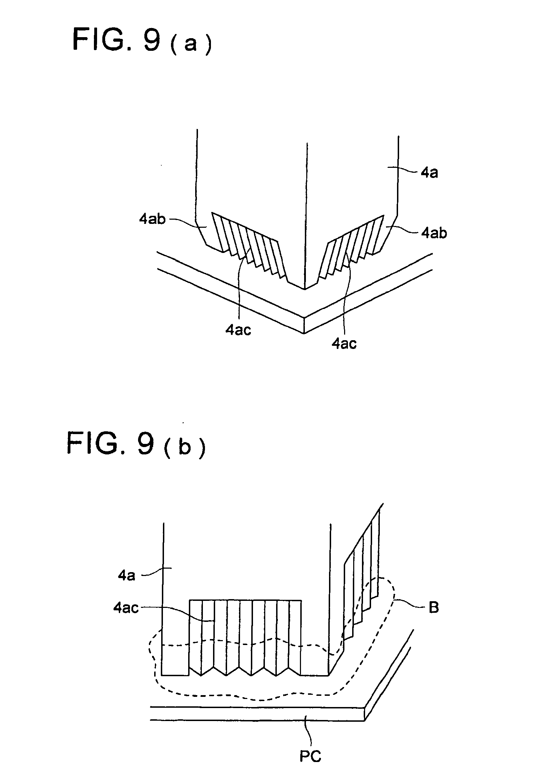

Each of Fig. 9(a) and Fig. 9(b) is a perspective view showing how an outer frame member is glued on a base board as another example in the image pickup device of the present invention,

Fig. 10 is a sectional view showing a conventional image pickup device,

Each of Fig. 11(a) and Fig. 11(b) is a sectional view showing how an outer frame member is glued on the base board in the conventional image pickup device,

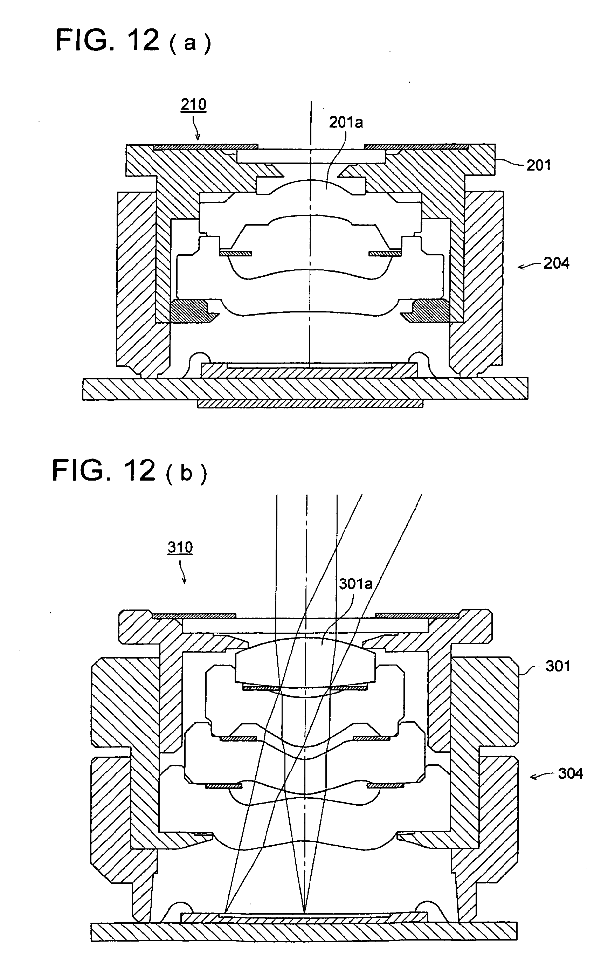

Fig. 12(a) and Fig. 12(b) represent other Examples, wherein Fig. 12(a) is a schematic sectional view of an image pickup device composed of an optical member having therein two lenses and of a lens frame which engages with the optical member, and Fig. 12(b) is a schematic sectional view of an image pickup device composed of an optical member having therein four lenses and of a lens frame which engages with the optical member.

### (Embodiment 1)

As shown in Figs. 1 and 2, image pickup device 10 is composed of base board PC, optical member 1, image sensor 2, diaphragm plate 3, lens frame 4, light shielding plate 5, filter 6, pressing member 7, positioning electric parts 8 and electric parts 9 arranged on the base board PC.

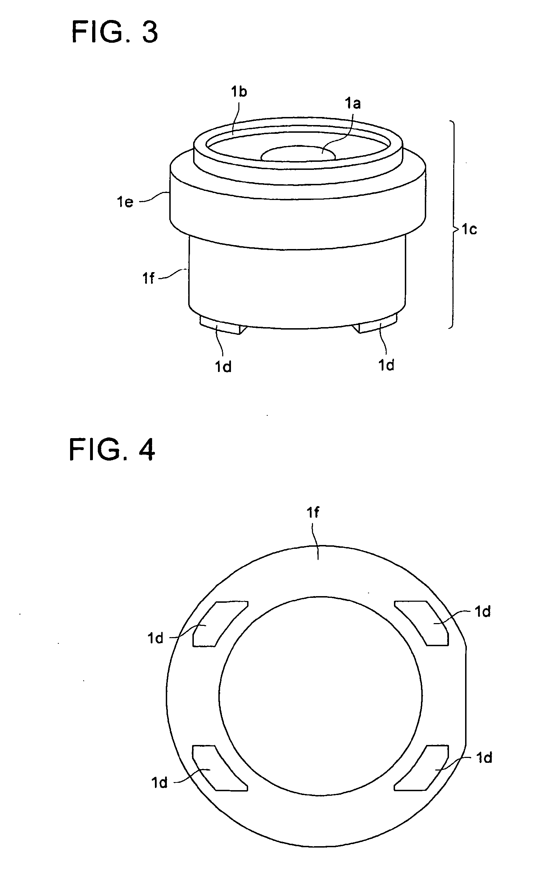

The optical member 1 is made of transparent plastic material, and as shown in Figs. 3 and 4, tubular leg portion 1c and convex-lens-formed lens portion 1a supported by the leg portion 1c are formed integrally in the optical member 1. The leg portion 1c has therein four contact portions 1d, upper leg portion 1e formed on a circumference on the upper end of the optical member 1, board-shaped top face portion 1b that closes the top end and lower leg portion 1f that is formed between the contact portions 1d and the upper leg portion 1e, and the lens portion 1a is formed at the center of the top face portion 1b.

The lower leg portion 1f is almost in a D-shaped form that is formed by an arc representing the interfitting part in terms of a shape and by a chord connecting both ends of the arc on a plane that is perpendicular to the optical axis.

Further, the diaphragm plate 3 which is made of material having a light-shielding property and has aperture 3a representing the first diaphragm that prescribes f-number of the convex lens portion 1a is fixed with an adhesive B on a circumference of the lens portion 1a on the upper part of the top face portion 1b.

Outside the optical member 1, there is arranged lens frame 4 representing an outer frame member made of material having lighttightness.

On the lens frame 4, there are provided prismatic lower portion 4a and cylindrical upper portion 4b, as is apparent from Fig. 2. A lower end portion of the lower portion 4a is a place of adhesion for the lens frame 4 to be attached on the base board PC, and as shown in Fig. 1, an inner side surface and an outer side surface of the lens frame 4 are cut obliquely toward bottom surface 4aa at a prescribed angle, and thus, chamfered portions 4ab and 4ab each having a slanting surface are formed respectively inside and outside. When the lower portion 4a of the lens frame 4 is brought into contact with base board PC to be attached thereon, the adhesive B is coated on the boundary between the base board PC and the bottom surface 4aa left from chamfering plus chamfered portions 4ab and 4ab to fix them.

Figs. 7(a) and 7(b) show how lens frame 4 is stuck on the base board PC at an adhesion part. As shown in Fig. 7(a), when the bottom surface 4aa of lens frame 4 is brought into contact to be fixed after coating an adhesive on the base board PC, the adhesive B lie between the bottom surface 4aa and the base board PC between lens frame 4 and the base board PC, and the adhesive B is in contact broadly with inclined slopes of chamfers 4ab and 4ab and with the surface of the base board PC, thus, the lens frame 4 is fixed on the base board PC.

Being fixed as in the foregoing, the lens frame 4 is fixed on the base board PC more firmly, compared with an occasion where the bottom surface of lens frame 4 having no chamfer on its lower end portion is stuck on base board PC as in the past.

Further, when the lens frame 4 is pressed down from the upper portion to be brought into contact with base board PC having thereon coated the adhesive B, the lens frame 4 can be fixed to the base board PC while preventing that bubbles are generated between the adhesive B and the lens frame 4 in the course of adhesion, because chamfers 4ab and 4ab form inclined slopes. Due to this, the lens frame 4 can be fixed more firmly on the base board PC. Further, by supplying the adhesive B evenly to the space between chamfered portion 4ab and the base board PC, it is possible to make the base board PC and the lens frame 4 to be in contact each other more closely and thereby to improve waterproof, which is preferable.

Further, by making the base board PC and the lens frame to be fixed each other in a way to make both of them to be in contact, it is possible to mount the lens frame 4 by preventing uneven height of the lens frame 4 caused by lack of uniformity in a thickness of the adhesive B, which makes assembly to be easy.

In addition, if fixing is conducted with the adhesive B existing between chamfer 4ab and base board PC, it is possible to fix the base board PC and the lens frame 4 firmly without increasing an amount of the adhesive, which is different from the past, and manufacturing cost can be reduced, which is preferable.

Incidentally, as a method for fixing the base board PC and the lens frame 4 together, the adhesive B may be coated either on the lens frame 4 or on both of the base board PC and the lens frame 4.

As chamfer 4ab formed on lower portion 4a of the lens frame 4, it may be formed only on an inner side surface or an outer side surface of the lens frame 4 as shown in Fig. 8. As shown in Fig. 9(a), serrated portion 4ac is formed on an inclined slope of chamfer 4ab on the lower portion 4a of the lens frame 4. Owing to this serrated portion 4ac, the base board PC and the lens frame 4 can be fixed together more firmly, because an area of adhesion between the adhesive B and the lens frame 4 becomes greater. If a concave portion and a convex portion of the serrated portion are formed to be in the direction from the bottom surface 4aa of the lens frame 4 to the side of the lower portion 4a alternately as shown in Fig. 9(a), with respect to the serrated portion 4ac, bubbles are not generated on the adhesion part when the lens frame 4 is stuck to the base board PC, and they are fixed firmly, which is preferable.

Incidentally, even when serrated portion 4ac is formed on the side surface in the vicinity of an adhesion part which is present in the direction perpendicular to the base board PC as shown in Fig. 9(b), an area of adhesion between the adhesive B and lens frame 4 can be made large, and fixing between the base board PC and the lens frame 4 can be made to be more firm than that in the past.

Hereupon, the adhesive B used for fixing between the base board PC and the lens frame 4 will be explained. The adhesive B is a resin of a compound hardening type that can be hardened by irradiation of ultraviolet radiation or by other means. As the other means, there are given heat, water, a hardening agent or a hardening-promoter.

As resin of a compound hardening type which can be hardened by either heat or irradiation of ultraviolet radiation (let it be assumed as an adhesive B1), there are given, for example, Three Bond 3012 (registered trademark) and World Lock No. 863 (registered trademark).

As a resin of a compound hardening type which can be hardened by either water or irradiation of ultraviolet radiation (let it be assumed as adhesive B2), there is given, for example, Three Bond 3056 (registered trademark). As a resin of a compound hardening type which can be accelerated in terms of hardening by a hardening agent or a hardening-promoter and can be hardened by irradiation of ultraviolet radiation (let it be assumed as an adhesive B3), there is given, for example, Three Bond 3006 (registered trademark) for which Three Bond 3095 (registered trademark) is used as a hardening-promoter.

Details of the fixing method for base board PC and lens frame 4 employing the aforesaid adhesives B1, B2 and B3 will be described later.

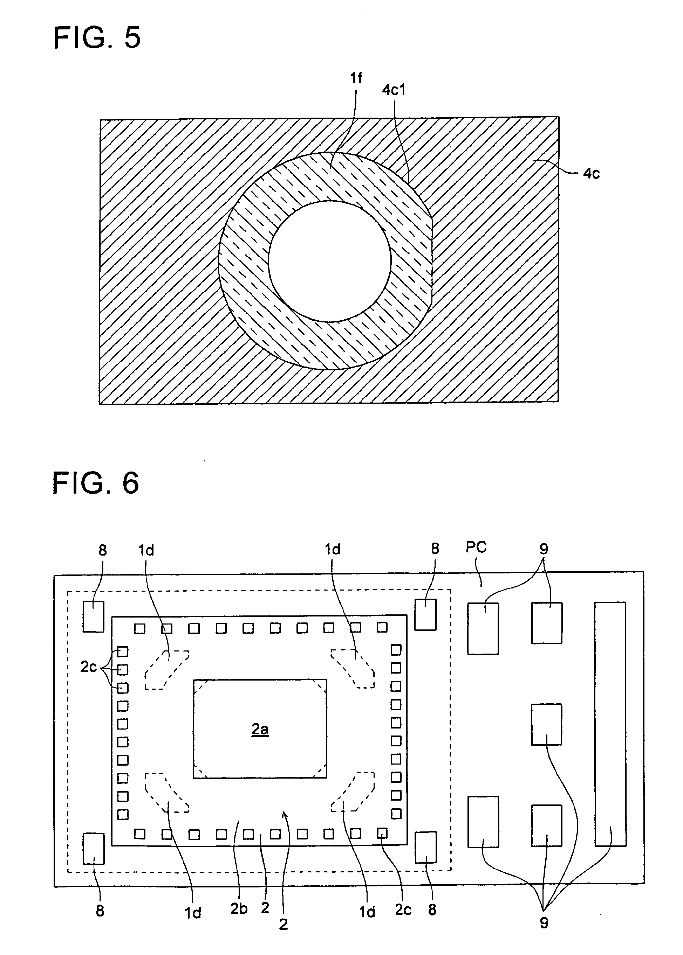

On the circular inner surface of partition wall 4c formed to be projected to the inside in a boundary portion between lower portion 4a and upper portion 4b of lens frame 4, there is provided D-shaped groove 4c1 that corresponds to lower leg portion 1f of the optical member 1, as shown in Fig. 5, and the lower leg portion 1f is fitted in the D-shaped groove 4c1 closely. Therefore, it is possible to position the lens portion 1a to photoelectric converting portion 2a accurately in the direction perpendicular to an optical axis, only by positioning and arranging the base board PC and lens frame 4 by using, for example, an optical sensor provided in an automatic assembly machine so that the center of the circular aperture portion on the partition wall 4c and the center of photoelectric converting portion 2a of image sensor 2 described later may agree with each other.

On the other hand, light-shielding plate 5 is mounted on the top of the upper portion 4b of the lens frame 4 with the adhesive B. The light-shielding plate 5 has, on its center, aperture 5a serving as a second diaphragm. Filter 6 made of material having infrared absorption characteristics is connected to the bottom side of the aperture 5a at the center of the light-shielding plate 5, with the adhesive B.

The light-shielding plate 5 and the filter 6 constitute a cover member. Since the base board PC, lens frame 4 and cover member are joined closely each other as stated above, image pickup device 10 has a dust-proof and moisture-proof structure.

In Fig. 1, pressing member 7 constituted by an elastic member such as, for example, a coil spring is arranged between the optical member 1 and the light-shielding plate 5. When the light-shielding plate 5 is mounted on the lens frame 4, the light-shielding plate 5 presses pressing member 7, and the pressing member 7 deforms elastically. This pressing member 7 presses the optical member 1 downward in Fig. 1 with prescribed pressing force, to urge the optical member 1 to image sensor 2. In this case, when a force toward the lower image sensor 2 from the light-shielding plate 5 is applied, pressing member 7 deforms elastically, and thus, buffer action to absorb the force is operated. Therefore, the force is not transmitted directly to the image sensor 2 and damage of the sensor 2 can be prevented.

In Fig. 6, image sensor 2 is composed, for example, of a CMOS (Complementary Metal Oxide Semiconductor) type image sensor. On the top face of the base board PC, there is attached rectangular lamina-shaped image sensor 2 with its bottom surface touching the top face of the base board PC. At the center of the top face of the image sensor 2, there are arranged pixels in a two-dimensional way so that photoelectric converting portion 2a having a light-receiving surface is formed. Processing portion 2b is formed outside the photoelectric converting portion 2a, and a plurality of circuit pads 2c are arranged in the vicinity of an outer edge of the processing portion 2b. The circuit pad 2c representing a terminal for connection is connected to the base board PC through wire W as shown in Fig. 1. The wire W is connected to a prescribed circuit on the base board PC.

Further, contact portion 1d of the optical member 1 is protruded from the bottom end of leg portion 1c to be in a shape shown in Fig. 4, and constitutes a part of the leg portion 1c. In the present embodiment, the optical member 1 is arranged under the condition wherein only contact portion 1d is in contact with processing portion 2b of the image sensor 2, as shown with broken lines on the image sensor 2 in Fig. 6. With respect to flatness on the surface, therefore, only the bottom surface of the contact portion 1d is required to be kept in a prescribed range. Further, the number of contact portions 1d is four, and a center of gravity of the optical member 1 comes to the center of the contact portions 1d. Therefore, it can be said that the contact portions 1d have positions and forms which make the optical axis of lens portion 1a to be perpendicular to a plane when the optical member 1 is placed individually on the plane. Accordingly, even when there is a slight clearance in the interfitting part where an outer circumferential surface of the optical member 1 is fitted in an inner circumferential surface of lens frame 4, the optical axis crosses photoelectric converting portion 2a of image sensor 2 at right angles when the contact portion 1d is brought into contact with processing portion 2b of image sensor 2, and images with less distortion can be obtained.

In this case, it is preferable that a load from contact portion 1d is not more than 500 g (not more than 1000 g/mm² in terms of a surface pressure), because there is a fear that image sensor 2 is damaged when this load (surface pressure) is exceeded. When blur of images caused by vibration is taken into consideration, however, it is preferable that a load from contact portion 1d is not less than 5 g. The load of this kind can be managed properly by selecting a wire diameter and the number of turns of a coil spring which is pressing member 7. The surface pressure in this case is one obtained by dividing a load applied on image sensor 2 through contact portion 1d of the optical member with an area of the surface which is in contact with contact portion 1d and is facing lens portion 1a.

In the present embodiment, gap Δ is formed between a bottom surface of upper leg portion 1e of the optical member 1 and partition wall 4c of lower portion 4a of lens frame 4, under the condition that the contact portion 1d is in contact with processing portion 2b of image sensor 2. Therefore, distance L between the lens portion 1a and photoelectric converting portion 2a of the image sensor 2 (namely, positioning in the direction of an optical axis) can be established accurately by the length of leg portion 1c. Though the number of contact portions 1d in the present embodiment is four, it may also be one, two or three. Further, the contact portion may also be a ring-shaped one that is formed along cylindrical leg portion 1c of the optical member 1, provided that interference with circuit pad 2c can be avoided.

Further, since optical member 1 is made of plastic material, it is also possible to reduce a deviation of a focusing position caused by a change in refractive index of lens portion 1a in the case of temperature changes. Namely, in the plastic lens, when its temperature rises, refractive index of the lens is lowered, and its focusing position is changed to be farther from the lens. Since the leg portion 1c extends when temperature rises, on the other hand, there is an effect to reduce a deviation of a focusing position. Incidentally, the optical member 1 of the present embodiment is lighter than a glass lens when their volumes are the same each other, and is excellent in terms of shock absorption characteristics, because the optical member 1 is made of plastic material whose specific gravity is relatively low. Therefore, even when image pickup device 10 is dropped accidentally, damage of image sensor 2 can be restrained to the utmost, which is an advantage.

In the case of the structure wherein optical member 1 can rotate freely in lens frame 4, contact portion 1d interferes with circuit pad 2c, therefore, there is provided a rotation-preventing mechanism which makes it possible to assemble while regulating a rotation of the optical member 1.

To be concrete, the rotation-preventing mechanism is composed of lower leg portion 1f which is almost D-shaped representing an interfitting part that is fitted in the lens frame and of D-shaped groove 4c1 that is an interfitting part in partition wall 4c of lens frame 4, as shown in Figs. 4 and 5.

Namely, when the lower portion 1f of the optical member 1 is inserted in the D-shaped groove 4c1, the optical member 1 is regulated in terms of its rotation around an optical axis, and positions on two axes in the horizontal plane can be determined.

Positioning electric parts 8 are represented, for example, by a capacitor, a resistance and a diode, and they are arranged to be close to lens frame 4 between image sensor 2 on base board PC and lens frame 4 in Fig. 1. Further, a height from the PC base board to a top end portion of the positioning electric parts 8 is greater than that from the PC base board to a top end portion of the image sensor 2. In Fig. 6, four positioning electric parts 8 are arranged to surround a square inside the adherence part (a portion enclosed with dotted lines to be a square in Fig. 6) of the lens frame 4. Therefore, the positioning electric parts 8 serve as an index for positioning the lens frame 4 when adhering the lens frame 4 on the base board PC. Further, the top end of the positioning electric parts 8 is higher than that of image sensor 2, which prevents that the lens frame 4 comes in contact with the image sensor 2 to damage a wire and others.

Incidentally, the positioning electric parts 8 have only to be electric parts which are required by image pickup device 10, without being limited, for example, to a capacitor, a resistance and a diode.

Electric part 9 is one that is required for operating image pickup device 10 in addition to the positioning electric parts 8.

Operations of the present embodiment will be explained as follows.

Lens portion 1a of optical member 1 forms an image of an object on photoelectric converting portion 2a of image sensor 2. The image sensor 2 can convert electric signals corresponding to an amount of light received into image signals to output through circuit pad 2c and wire W.

Further, in the present embodiment, it is possible to make adjustment about a focusing position of lens portion 1a to be unnecessary in the course of assembling, by controlling dimensional accuracy of leg portion 1c of optical member 1 (including contact portion 1d), namely, by controlling accuracy of the aforesaid distance L, because optical member 1 is mounted on processing portion 2b of image sensor 2 without being mounted on base board PC. Incidentally, in order to make adjustment about a focusing position to be unnecessary, it is necessary to limit a deviation between photoelectric converting portion 2a of image sensor 2 and an image point of lens portion 1a of the optical member 1 to about ± F x 2P (F: f-number of a lens portion, P: pixel pitch of image sensor) in terms of air-converted length.

In the present embodiment, positions of lens portion 1a and photoelectric converting portion 2a of image sensor 2 in the direction of an optical axis can be determined by contact portion 1d of leg portion 1c of optical member 1 that comes in contact with processing portion 2b of image sensor 2. Further, when lens frame 4 is mounted on base board PC with photoelectric converting portion 2a of image sensor 2 serving as a standard for positioning, positions of lens portion 1a and photoelectric converting portion 2a of image sensor 2 in the direction perpendicular to an optical axis are determined, which makes it possible to attain high positioning accuracy at low cost.

In particular, when circuit pad 2c and wire W for connecting image sensor 2 with base board 2 are formed on processing portion 2b of the image sensor 2, if contact portion 1d of leg portion 1c is structured to come into contact with processing portion 2b at the position closer than circuit pad 2c to photoelectric converting portion 2a, it is possible to secure a large contact area of the contact portion 1d while keeping the image sensor 2 to be of a compact structure, and thereby, to stabilize optical member 1 and to control surface pressure on the contact surface to be low, thus, interferences of circuit pad 2c and wire W are suppressed while image sensor 2 is protected, and highly accurate positioning can be attained. Incidentally, the lens frame 4 is adhered to base board PC with the adhesive, and together with other two adhered portions, the outside of image pickup device 10 is kept to be in the state sealed hermetically so that foreign substances may not invade, thus, bad influences of foreign substances on the photoelectric converting portion 2a of image sensor 2 can be eliminated. It is preferable that the adhesive used for the foregoing have moisture-proof or hygroscopic property. Due to this, it is possible to prevent deterioration on the surface of the image sensor 2 and pad 2c caused by an invasion of moisture.

Since there is provided pressing member 7 that presses a top face on the step section of upper leg portion 1e of optical member 1 in the direction of an optical axis with prescribed elastic force, it is possible to press leg portion 1c against processing portion 2b of image sensor 2 with appropriate pressing force (the force corresponding to a load ranging from 5 g to 500 g) by using elastic force of the pressing member 7. Therefore, even when deformation such as a warp of the part is caused by aging changes despite easy positioning of optical member 1 and image sensor 2 in the direction of an optical axis, it is possible to urge the optical member 1 against image sensor 2 with stable elastic force, and thereby to control backlash of the optical member 1 in the case of occurrence of vibration, and further to prevent that excessive stress is caused on processing portion 2b of image sensor 2 in which a circuit is arranged, when a shock is caused. Further, when large forces such as impact forces are applied in the direction of an optical axis of lens frame 4, these forces are not transmitted directly to the image sensor 2 though they are transmitted to base board PC, which is preferable from the viewpoint of protection of the image sensor 2. Incidentally, as pressing member 7, an elastic member such as, for example, a coil spring is used. In addition, urethane or sponge may also be used, but an elastic material which is of resin or metal that can exhibit stable elastic force for a long time is preferable.

Since the cover member composed of light-shielding plate 5 and filter 6 is arranged to be closer to an object than from lens portion 1a, the lens portion 1a is not exposed to the outside to be protected, and sticking of foreign substances to the lens surface is prevented. Further, filter 6 is made of substances having infrared absorption characteristics, and it is not necessary to provide an infrared blocking filter separately, and thereby the number of parts can be reduced, which is preferable. In place of giving infrared blocking characteristics to filter 6, it is considered to form optical member 1 itself with material having infrared absorption characteristics or to coat a film having infrared blocking characteristics on the surface of lens portion 1a.

Further, in the course of assembling, optical member 1 can be inserted in lens frame 4 from the object side, under the condition that light-shielding plate 5 is taken out of lens frame 4, and then, the light-shielding plate 5 can be mounted on the lens frame 4. Due to the structure of this kind, incorporation of the optical member 1 is improved, and automatic assembly can be carried out easily. If an air-escape vent is formed on either one of lower portions 4a of lens frame 4 in this case, it is possible to conduct assembling easily even if the gap between the lens frame 4 and the optical member 1 is small. However, it is preferable to fill this air-escape vent with fillers after assembling so that invasion of foreign substances from the outside and surface deterioration of image sensor 2 and pad 2c may be controlled. Further, it is preferable that the fillers have light-shielding properties so that they may restrain light leakage. Incidentally, it is possible to insert the optical member 1 after the lens frame 4 has been glued on the base board PC, or it is possible to mount the optical member 1 on the lens frame 4 first and then, to glue the unit of the optical member 1 and the lens frame 4 on the base board PC, by which the degree of freedom of the process can be secured. In the case of the latter assembly, partition wall 4c of the lens frame 4 can also serve as the function to prevent falling out of the optical member 1.

Further, since the leg portion 1c of the optical member 1 is arranged in the vicinity of photoelectric converting portion 2a of image sensor 2, reflecting on the leg portion 1c and entering the photoelectric converting portion 2a by a light flux that is not contributing to image forming are feared to be causes for occurrence of ghost and flare. To prevent this, it is effective to arrange the second diaphragm (aperture 5a) that regulates peripheral light fluxes to be closer to an object than from the first diaphragm (aperture 3a) that prescribes f-number of lens portion 1a, and to reduce incidence of unwanted light. Incidentally, further effects may be obtained by making the aperture 5a of the second diaphragm to be a rectangle, because field angles are different depending on the directions of a shorter side, a longer side and a diagonal line of photoelectric converting portion 2a of image sensor 2. In addition, though this function is owned by aperture 5a of light-shielding plate 5 in the present embodiment, it is also possible to form a diaphragm by coating a film having light-shielding property on an area other than a necessary aperture on the side of filter 6 closer to an object. Further, for the same reason, it is preferable to apply processing to prevent internal reflection on at least a part of leg portion 1c. The processing to prevent internal reflection includes, for example, forming the surface provided with microscopic unevenness to diverge light flux that does not contribute to image forming, and applying of reflection-preventing coating or of coating having low reflection characteristics.

Further, since diaphragm plate 3 equipped with aperture 3a is provided on the plane of incidence side of lens portion 1a, it is possible to make a light flux entering photoelectric converting portion 2a of image sensor 2 to enter at an angle close to verticality, namely, to realize a structure close to a telecentric type, and thereby to obtain images of high image quality. Further, by making a form of lens portion 1a to be a form of a positive lens whose surface having sharp curvature faces the object side, a distance between the first diaphragm (aperture 3a) and a principal point of the lens portion 1a can be made great, resulting in a preferable structure that is closer to a telecentric type.

Next, how to assemble each constituent member of image pickup device 10 will be explained. In the present embodiment, the adhesive B1 which can be hardened by any of heat and ultraviolet radiation is used as an adhesive.

First, image sensor 2 equipped with photoelectric converting portion 2a is mounted at a prescribed position on base board PC with wire W, and then, the adhesive B1 are coated at a part of adhesion with lens frame 4 on the base board PC.

After that, positioning of lens frame 4 on the base board PC is conducted while confirming a fixing position by bringing lower portion 4a of lens frame 4 into contact with positioning electric part 8 on the base board PC from the upper portion of the fixing position. Then, ultraviolet radiation is irradiated on the adhesion part between the base board PC and lens frame 4 to harden the adhesive B1 for conducting temporal fixing of the lens frame 4 (first process, temporal fixing process). Intensity of the irradiation of ultraviolet radiation and a period of time of the irradiation may be established properly depending on a type of an adhesive to be used, an amount thereof to be used and an extent of desired hardening, and for example, intensity of irradiation that is 20% of intensity for perfect hardening is preferable.

Next, positioning for two axes in the horizontal direction of optical member 1 is conducted by inserting lower leg portion 1f of optical member 1 in D-shaped groove 4c1 that is formed at an interfitting part of partition wall 4c of lens frame 4 from the upper portion of the lens frame 4, and contact portion 1a is brought into contact with image sensor 2 of base board PC.

Then, after placing pressing member 7 on the upper side of optical member 1, light-shielding plate 5 is engaged with upper portion 4b of the lens frame 4 to fix the light-shielding plate 5 to the lens frame 4 with adhesive B1. Further, filter 6 is mounted on aperture portion 5a of the light-shielding plate 5 to be fixed with the adhesive B1. After termination of assembly of these constituent members of image pickup device 10, a part of adhesion between base board PC and lens frame 4 and adhesive B1 at that part are heated by the use of a heating device such as an electric heater. This heating makes the adhesive B1 to be hardened thoroughly for regular fixing (second process, regular fixing process). After heating, the adhesive B1 are left to be cooled so that they are hardened thoroughly.

By conducting temporal fixing process and regular fixing process separately on the adhesion part between base board PC and lens frame 4 and by conducting assembling process for optical member 1 and light-shielding plate 5 between the temporal fixing and the regular fixing, as stated above, it is possible to assemble with a degree of freedom to a certain extent in the course of assembling process. It is further possible to conduct temporal fixing by ultraviolet radiation within a short period of time by adjusting a level of hardening, and to conduct fixing of the adhesive B1 firmly by heating after termination of assembling.

Therefore, it is possible to fix an outer frame member firmly while securing a degree of freedom to a certain extent in an assembling process. It is further possible to move to the succeeding assembling process after hardening the adhesive B1 with ultraviolet radiation to a certain extent for temporal fixing, without waiting until the adhesive is thoroughly hardened, when attaching the outer frame member on the base board, and even when cooling time is required after regular fixing by heating, an influence on a cycle time for assembling is small. Therefore, a cycle time for production of image pickup device 10 can be shortened, and productivity can be improved, which is preferable.

### (Embodiment 2)

In Embodiment 2, there will be explained a method to produce image pickup device 10 by the use of the adhesive B2. Incidentally, constituent members of the image pickup device 10 are the same as those in Embodiment 1, and explanation for them will be omitted accordingly.

On the base board PC on which image sensor 2 is attached, there is coated the adhesive B2 at a part for adhesion with lens frame 4. After that, lower portion 4a of the lens frame 4 is brought into contact with an adhesion part on the base board PC, in the same way as in Embodiment 1. Then, ultraviolet radiation is radiated on a part for adhesion between the base board PC and the lend frame 4 to harden the adhesive B2 slightly for temporal fixing of the lens frame 4 (first process, temporal fixing process).

After incorporating optical member 1 in lens frame 4 and placing pressing member 7 on the upper side of the optical member 1 in the same way as in Embodiment after temporal fixing process, light-shielding plate 5 is fixed on upper portion 4b of lens frame 4. Further, filter 6 is attached on aperture portion 5a of the light-shielding plate 5. After termination of incorporating these constituent members of the image pickup device 10, air holes in the part of adhesion between base board PC and lens frame 4 are filled up with the adhesive B2 completely. When the image pickup device 10 is left under this condition, the adhesive B2 in the adhesion part between base board PC and lens frame 4 absorb moisture in the air to be hardened. This hardening makes the lens frame 4 to be fixed regularly on the base board PC (second process, regular fixing process). Incidentally, after the adhesive B2 absorb moisture and are hardened, the adhesive B2 may also be irradiated by ultraviolet radiation for ensuring further fixing.

By fixing the base board PC and the lens frame 4 with temporal fixing and regular fixing as stated above, it is possible to fix the outer member firmly while securing the degree of freedom to a certain extent in an assembling process. After termination of assembling, it is possible to harden the adhesive B2 more through moisture absorption, and to fix more firmly. Therefore, after conducting temporal fixing by hardening the adhesive B2 to a desired extent within a short period of time by ultraviolet radiation, it is possible to advance to the succeeding assembling process, and thereby, to shorten a cycle time for production of image pickup device 10, and productivity can be improved, which is preferable.

When the adhesive B2 absorb moisture, moisture in the air inside the lens frame 4 is taken in the adhesive B2. Therefore, the inside of the lens frame 4 is dehumidified, and a chance of dew condensation in the image pickup device 10 is reduced, thus, troubles such as failures in the image pickup device 10 are prevented, which is preferable. Further, even when a certain period of time is required for absorption of moisture in the regular fixing process, an influence on a cycle time for production is small, which is preferable.

### (Embodiment 3)

In Embodiment 3, there will be explained a method to produce image pickup device 10 by the use of the adhesive B3. Incidentally, constituent members of the image pickup device 10 are the same as those in Embodiment 1, and explanation for them will be omitted accordingly.

On the base board PC on which image sensor 2 is attached, there is coated a hardening agent or a hardening-promoter on an adhesion part with lens frame 4. As the hardening agent or the hardening-promoter, a hardening agent or a hardening-promoter which has an effect to promote hardening is selected properly, and is coated on the adhesion part for the base board PC or the lens frame 4.

After that, adhesion agents B3 are coated on the base board PC on which the hardening agent or the hardening-promoter has been coated, and the lower portion 4a of the lens frame 4 is brought into contact with the adhesion part of the base board PC in the same way as in Embodiment 1. Since a hardening agent or a hardening-promoter has been coated on the adhesion part of the base board PC or the lens frame 4, the adhesion agents B3 are urged to be hardened, and the base board PC and the lens frame 4 are fixed temporarily (first process, temporal fixing).

After temporal fixing process, optical member 1 is incorporated in lens frame 4 in the same way as in Embodiment 1, and after pressing member 7 is placed on the upper side of the optical member 1, light-shielding plate 5 is fixed on upper portion 4b of lens frame 4. Further, filter 6 is attached on aperture portion 5a of the light-shielding plate 5. After termination of assembling of these constituent members of image pickup device 10, the adhesion part for the base board PC and the lens frame 4 is irradiated by ultraviolet radiation so that adhesion agents B3 may be hardened thoroughly and thereby the lens frame 4 may be fixed regularly on the base board PC (second process, regular fixing process).

By fixing the base board PC and the lens frame 4 with temporal fixing and regular fixing as stated above, it is possible to fix the outer member firmly while securing the degree of freedom to a certain extent in an assembling process. After termination of assembling, it is possible to harden the adhesive B3 more through ultraviolet radiation, and to fix more firmly. Therefore, after conducting temporal fixing by hardening the adhesive B3 to a certain extent by hardening agents or hardening-promoters, it is possible to advance to the succeeding assembling process, and thereby, to shorten a cycle time for production of image pickup device 10, and productivity can be improved, which is preferable. Incidentally, in Example 3, regular fixing may be left without being irradiated by ultraviolet radiation. Even in this case, the adhesive can be hardened thoroughly with the lapse of time.

When hardening means are used properly by employing the adhesive B of a compound hardening type as in Embodiment 1 - Embodiment 3, timing for hardening the adhesive can be controlled easily, which is preferable.

The invention has been explained as stated above, referring to the Embodiments to which, however, the invention is not limited, and it can naturally be modified or improved. For example, with respect to an uneven portion, it is also possible to form an irregular uneven portion to increase a surface area, in addition to the regular serrated portions shown in Figs. 9(a) and 9(b). Further, an angle of an inclined slope formed on a chamfer can also be established and modified properly. Though image sensor 2 is connected to base board PC by means of wire W in the present embodiment, there is also considered an arrangement wherein wires creep inside the image sensor 2 and signals are taken out of the back (the side opposite to photoelectric converting portion 2a) or of the side of the image sensor 2. Due to this arrangement, a broad circumferential surface of the image sensor 2 can be secured and wiring can be conducted easily.

Though contact portion 1d of optical member 1 is in contact with the upper surface of the image sensor 2 in the present embodiment, the contact portion 1d may also be in contact with base board PC or with both of the image sensor 2 and base board PC.

Further, though the image sensor 2 is of the structure of a bare-chip in the present embodiment, it is conceivable to stick a protective member such as glass or film on the upper surface or the bottom surface of the image sensor to create the structure which is more durable. Further, base board PC may also be a flexible one without being limited to the hard one.

The image pickup device of the invention is considered to be capable of being incorporated in various equipment such as a cellphone, a personal computer, PDA, AV set, a television set and a household appliance.

Fig. 12(a) represents another Example showing a schematic sectional view of image pickup device 210 composed of optical member 201 whose lens portion 201a has two lenses and of lens frame 204 which engages with the optical member 201. In the same way, Fig. 12(b) represents still another Example showing a schematic sectional view of image pickup device 310 composed of optical member 301 whose lens portion 301a has four lenses and of lens frame 304 which engages with the optical member 301.

Hereupon, when a glass mold lens is used for the first lens which is closest to an object in each of Figs. 12(a) and 12(b), it is necessary to establish a temperature for press working in mold pressing to be high in general, if the glass has its high glass transition point (Tg), which makes a metal mold for molding to be subject to wear and damage. As a result, the number of times for replacement of a metal mold for molding and the number of times of maintenances are increased, resulting in cost increase. When using a glass mold lens, therefore, it is preferable to use glass materials whose glass transition point is 400°C or less.

It is preferable, from the viewpoint of dispersion and refractive index, to use a glass lens in an optical system for photographing, but it is necessary, in the optical system for photographing, to reduce the number of lenses by employing an aspherical lens, because white light is a prior condition. In this case, the aspherical lens is naturally manufactured by transferring the surface form through press molding by means of die-stamping, because it is impossible to manufacture through a lens smoothing and polishing method.

In this case, glass materials are heated to be subjected to die-stamping as a matter of course, and if a temperature in that case is high (in other words, the melting point is high, glass transition point is high), a die to be used for pressing is deteriorated quickly by heat (not durable for a large number of shots).

Further, when making a die, it is necessary to select a material for the die that is proof against high temperature, resulting in less choices for the materials.

In addition, in the case of working of die-stamping, a glass material is heated up to high temperature, and then, stamping is conducted, and after that, cooling is required, which makes a cycle time to be long.

If a glass material having low melting point is used, on the contrary to the foregoing, the problems stated above are solved. Namely, choices for selection of a material for the die are broadened, a die life is prolonged and a cycle time in the actual working can be shortened.

In the invention, a chamfer is formed toward the bottom surface from the side of an outer frame member, and therefore, an adhesion area where the adhesive which fix an outer frame member on a base board are in contact with the outer frame member in a chamfered portion of the outer frame member, grows greater, thus, the outer frame member can be fixed firmly with the base board.

Further, it is possible to prevent that a height of the outer frame member on the base board becomes uneven, by assembling while keeping the bottom surface of the outer frame member to be in contact with the base board, resulting in easy assembly work.

Further, if a chamfer is formed in a way that the chamfer is chamfered from the inside surface and from the outside surface of the outer frame member, an area of adhesion between the adhesive and the outer frame member can be made greater, and the outer frame member can be fixed more firmly on the base board.

In addition, since a serrated portion is formed on an inclined slope of the chamfer, the surface of adhesion between the adhesive and the outer frame member can be made to be greater, and the outer frame member can be fixed more firmly on the base board.

Further, if each of the concave portion and the convex portion is formed to be in the direction from the bottom surface to the side of the outer frame member, it is possible to prevent that bubbles are formed in the concave portion and in the convex portion when the outer frame member and the base board are fixed together, thus, both of them can be fixed through a broader surface of adhesion.

In the invention, it is possible to use a process to harden the adhesive by dividing it into two steps. Therefore, an outer frame member can be fixed firmly while securing a degree of freedom to a certain extent in the assembling process. Further, using a plurality of hardening means properly by employing an adhesive of a compound hardening type makes it easy to control timing for hardening the adhesive, which is preferable.

In addition, in the case of mounting the outer frame member on the base board, it is possible to advance to the following assembly process after temporal fixing by hardening the adhesive to a certain extent, without waiting until the adhesive are hardened thoroughly. Therefore, a cycle time for production can be shortened, and productivity can be improved, which is preferable.

Further, in the invention, when the first hardening process and the second hardening process are conducted separately by conducting either one of the processes first and the other later, the outer frame member can be fixed on the base board through two steps of the temporal fixing and the regular fixing. Due to this, the degree of freedom in the production process after fixing the outer frame member is high, which makes it possible to produce image pickup devices in good condition.

If temporal fixing is carried out by irradiation of ultraviolet radiation, in addition, the adhesive can be hardened to the desired extent within a short period of time, and thereby, an influence on a cycle time for production is small, and temporal fixing can be carried out satisfactorily.

## Claims

1. Image pickup device (10), comprising
(a) a base board (PC) provided with an image sensor (2),
(b) an optical member (1) for converging light on the image sensor (2), and
(c) an outer frame member (4) glued by adhesive (B) on the base board (PC) for covering at least the image sensor (2),
wherein
a chamfer (4ab) Including a serrated portion (4ac) is formed at a prescribed angle from a side surface toward the bottom surface (4aa) of the outer frame member (4) on the adhesion part of the outer frame member glued on the base board (PC), the adhesive (B) being coated on a slope of the chamfer and on the bottom surface (4aa) which is left after chamfering.

2. Image pickup device of claim 1, wherein the position of the optical member (1) is regulated by the outer frame member (4) and by either one of the base board (PC) and the image sensor (2).

3. Image pickup device of claim 1 or 2, wherein the chamfer (4ab) is formed on each of the Inner side and the outer side of the outer frame member (4).

4. Image pickup device of claim 1, 2 or 3, wherein a concave portion and a convex portion of the serrated portion (4ac) are formed to be in direction from the bottom surface (4aa) of the outer frame member (4) to the side surface thereof.

5. Image pickup device of any one of claims 1 to 4, where in the adhesive (B) which sticks the base board (PC) and the outer frame member (4) together is a resin of a compound hardening type having both characteristics to be hardened by ultraviolet radiation and to be hardened by a hardening medium other than ultraviolet radiation.

6. Method for producing an image pickup device of any one of claims 1 to 5 provided with a base board (PC) having an image sensor (2), an outer frame member (4) that Is glued on the base board for covering at least the image sensor, and an optical member (1) for converging light on the image sensor, the method comprising
(a) providing the adhesive (B) of claim 5 that is a resin of a compound hardening type having characteristics to be hardened by ultraviolet radiation and characteristics to be hardened by a hardening medium other than ultraviolet radiation;
(b) coating the adhesive (B) on an adhesion part for the base board (PC) or the outer frame member(4), wherein a chamfer (4ab) including a servated portion (4ac) is formed at a prescribed angle from a side surface toward a bottom surface (4aa) of the outer frame member (4) on the adhesion part of the outer frame member.
(c) thereafter, bringing the base board into contact with the outer frame member, so that the adhesive is coated on a slope of the chamfer and on the bottom surface which is left after chamfering.
(d) hardening the adhesive coated on the adhesion part by ultraviolet radiation, and
(e) thereafter, hardening the adhesive coated on the adhesion part by the hardening medium other than ultraviolet radiation.

7. Method of claim 6, wherein the hardening by ultraviolet radiation is made to be a temporal fixing process, and the hardening by a hardening medium other than ultraviolet radiation is made to be a regular fixing process.

## Patentansprüche

1. Bildaufnahmevorrichtung (10) mit
(a) einem Laufboden (PC), der mit einem Bildsensor (2) versehen ist,
(b) einem optischen Element (1), um auf dem Bildsensor (2) Licht zusammenlaufen zu lassen, und
(c) einem äußeren Rahmenelement (4), das mit Hilfe von Klebstoff (B) auf dem Laufboden (PC) verklebt ist, um zumindest den Bildsensor (2) abzudecken,
wobei
eine Abfasung (4ab) einschließlich eines gezahnten Bereiches (4ac) in einem vorgeschriebenen Winkel von einer Seitenfläche zu der Unterseite (4aa) des äußeren Rahmenelementes (4) hin an dem Haftbereich des auf dem Laufboden (PC) verklebten äußeren Rahmenelementes ausgebildet ist, wobei der Klebstoff (B) auf eine Schräge der Abfasung und auf die Unterseite (4aa), die nach dem Abschrägen übrig bleibt, aufgetragen wird.

2. Bildaufnahmevorrichtung gemäß Anspruch 1, wobei die Position des optischen Elementes (1) von dem äußeren Rahmenelement (4) und von entweder dem Laufboden (PC) oder dem Bildsensor (2) geregelt wird.

3. Bildaufnahmevorrichtung gemäß Anspruch 1 oder 2, wobei die Abfasung (4ab) auf jeweils der Innenseite und der Außenseite des äußeren Rahmenelementes (4) ausgebildet ist.

4. Bildaufnahmevorrichtung gemäß Anspruch 1, 2 oder 3, wobei ein konkaver Bereich und ein konvexer Bereich des gezahnten Bereiches (4ac) derart ausgebildet sind, dass sie in Richtung von der Unterseite (4aa) des äußeren Rahmenelementes (4) zu dessen Seitenfläche hin liegen.

5. Bildaufnahmevorrichtung gemäß irgendeinem der Ansprüche 1 bis 4, wobei der Klebstoff (B), welcher den Laufboden (PC) und das äußere Rahmenelement (4) zusammenklebt, aus einem Harz einer aushärtenden Verbundart besteht, welches die Eigenschaft aufweist, sowohl durch Ultraviolettstrahlung auszuhärten als auch durch ein sich von Ultraviolettstrahlung unterscheidendes Härtemittel.

6. Verfahren zur Herstellung einer Bildaufnahmevorrichtung gemäß irgendeinem der Ansprüche 1 bis 5, welche versehen ist mit einem Laufboden (PC), der einen Bildsensor (2) aufweist, einem äußeren Rahmenelement, das auf den Laufboden aufgeklebt ist, um zumindest den Bildsensor abzudecken, und einem optischen Element (1), um auf dem Bildsensor Licht zusammenlaufen zu lassen, wobei das Verfahren aufweist
(a) Bereitstellung des Klebstoffs (B) gemäß Anspruch 5, der ein Harz einer aushärtenden Verbundart ist mit Eigenschaften durch Ultraviolettstrahlung auszuhärten und Eigenschaften durch ein sich von Ultraviolettstrahlung unterscheidendes Härtemittel auszuhärten;
(b) Auftragen des Klebstoffs (B) auf einen Haftbereich für den Laufboden (PC) oder das äußere Rahmenelement (4), wobei eine Abfasung (4ab) einschließlich eines gezahnten Bereiches (4ac) in einem vorgeschriebenen Winkel von einer Seitenfläche zu der Unterseite (4aa) des äußeren Rahmenelementes (4) hin an dem Haftbereich des äußeren Rahmenelementes ausgebildet ist,
(c) danach Kontaktherstellung zwischen dem Laufboden und dem äußeren Rahmenelement, so dass der Klebstoff auf eine Schräge der Abfasung und auf die Unterseite (4aa), die nach dem Abschrägen übrig bleibt, aufgetragen wird,
(d) Aushärtung des auf den Haftbereich aufgetragenen Klebstoffs durch Ultraviolettstrahlung, und
(e) danach Aushärtung des auf den Haftbereich aufgetragenen Klebstoffs durch das sich von Ultraviolettstrahlung unterscheidende Härtemittel.

7. Verfahren gemäß Anspruch 6, wobei die Aushärtung durch Ultraviolettstrahlung zu einem zeitweiligen Fixierverfahren gemacht wird und die Aushärtung durch ein sich von Ultraviolettstrahlung unterscheidendes Härtemittel zu einem regelmäßigen Fixierverfahren gemacht wird.

## Revendications

1. Dispositif de prise d'images (10), comprenant
(a) une planchette de base (PC) munie d'un détecteur d'images (2),
(b) un élément optique (1) pour faire converger de la lumière sur le détecteur d'images (2), et
(c) un élément de cadre extérieur (4) collé sur la planchette de base (PC) par un adhésif (B) pour couvrir au moins le détecteur d'images (2),
dans lequel
un chanfrein (4ab) comprenant une partie dentée (4ac) est formé sous un angle prescrit à partir d'une face latérale jusqu'à la face inférieure (4aa) de l'élément de cadre extérieur (4) sur la partie d'adhésion de l'élément de cadre extérieur collé sur la planchette de base (PC), l'adhésif étant appliqué sur une pente du chanfrein et sur la face inférieure (4aa) qui reste après le chanfreinage.

2. Dispositif de prise d'images selon la revendication 1, dans lequel la position de l'élément optique (1) est réglée par l'élément de cadre extérieur (4) et soit par la planchette de base (PC) soit par le détecteur d'images (2).

3. Dispositif de prise d'images selon la revendication 1 ou 2, dans lequel le chanfrein (4ab) est formé sur chacune de la face intérieure et de la face extérieure de l'élément de cadre extérieur (4).

4. Dispositif de prise d'images selon la revendication 1, 2, ou 3, dans lequel une partie concave et une partie convexe de la partie dentée (4ac) sont formées de sorte qu'elles s'étendent à partir de la face inférieure (4aa) de l'élément de cadre extérieur (4) dans la direction vers la face latérale de celui-ci.

5. Dispositif de prise d'images selon l'une quelconque des revendications 1 à 4, dans lequel l'adhésif (B) qui colle la planchette de base (PC) à l'élément de cadre extérieur (4) est une résine du type composé durcissant qui présente la caractéristique d'être durcie par radiation ultraviolette ainsi que par un durcissant qui est différent de la radiation ultraviolette.

6. Procédé de fabrication d'un dispositif de prise d'images selon l'une quelconque des revendications 1 à 5 muni d'une planchette de base (PC) comprenant un détecteur d'images (2), d'un élément de cadre extérieur (4) qui est collé sur la planchette de base pour couvrir au moins le détecteur d'images, et d'un élément optique (1) pour faire converger de la lumière sur le détecteur d'images (2), le procédé comprenant les étapes de
(a) mettre à disposition l'adhésif (B) selon la revendication 5 qui est une résine du type composé durcissant présentant des caractéristiques d'être durcie par radiation ultraviolette ainsi que par un durcissant qui est différent de la radiation ultraviolette ;
(b) appliquer l'adhésif (B) sur une partie d'adhésion pour la planchette de base (PC) ou l'élément de cadre extérieur (4), un chanfrein (4aa) comprenant une partie dentée (4ac) étant formé sous un angle prescrit à partir d'une face latérale jusqu'à la face inférieure (4aa) de l'élément de cadre extérieur (4) sur la partie d'adhésion de l'élément de cadre extérieur,
(c) ensuite, établir un contact entre la planchette de base et l'élément de cadre extérieur, de sorte que l'adhésif est appliqué sur une pente du chanfrein et sur la face inférieure qui reste après le chanfreinage,
(d) faire durcir l'adhésif appliqué sur la partie d'adhésion par radiation ultraviolette, et
(e) ensuite, faire durcir l'adhésif appliqué sur la partie d'adhésion par le durcissant qui est différent de la radiation ultraviolette.

7. Procédé selon la revendication 6, dans lequel le durcissement par la radiation ultraviolette est destiné à être un procédé de fixation temporaire et le durcissement par un durcissant qui est différent de la radiation ultraviolette est destiné à être un procédé de fixation régulier.
